# EUROPÄISCHE PATENTSCHRIFT

(11) **EP 3 931 540 B1**
(45) Veröffentlichungstag und Bekanntmachung des Hinweises auf die Patenterteilung: **10.09.2025**
(21) Anmeldenummer: 20701749.2
(22) Anmeldetag: 23.01.2020
(51) Int. Cl.: G01L 9/00, G01L 9/12, G01L 19/00, G01L 19/04, G01L 19/06, G01D 11/24, H01L 21/56, H01L 25/10, G01L 19/14

(54) **MESSGERÄT MIT EINEM SENSORELEMENT UND EINER MESS- UND BETRIEBSSCHALTUNG**
MEASURING DEVICE WITH A SENSOR ELEMENT AND A MEASUREMENT AND OPERATION CIRCUIT
APPAREIL DE MESURE POURVU D'UN ÉLÉMENT CAPTEUR ET CIRCUIT DE MESURE ET DE FONCTIONNEMENT

(30) Priorität: 26.02.2019 DE 102019104841
(43) Veröffentlichungstag der Anmeldung: 05.01.2022
(73) Patentinhaber: Endress+Hauser SE+Co. KG, 79689 Maulburg (DE)
(72) Erfinder: GIRARDEY, Romuald, 68730 Blotzheim (FR); PONATH, Nils, 79539 Lörrach (DE); BANNWARTH, Alexander, 79739 Schwörstadt (DE)
(74) Vertreter: Endress + Hauser Group Services (Deutschland) AG+Co. KG
(86) Internationale Anmeldenummer: PCT/EP2020/051626
(87) Internationale Veröffentlichungsnummer: WO 2020/173624

(56) Entgegenhaltungen:
- EP-A1- 1 063 504
- EP-A1- 1 126 259
- CN-B- 103 426 869
- DE-A1- 10 223 946
- DE-A1- 102006 035 274
- DE-A1- 102012 222 239
- DE-A1- 19 828 598
- JP-A- S57 206 842
- US-A1- 2005 277 227
- US-A1- 2009 236 733
- US-A1- 2015 362 392

## Beschreibung

Die vorliegende Erfindung betrifft ein Messgerät mit den Merkmalen des Oberbegriffs des ersten Anspruchs. Ein gattungsgemäßes Messgerät mit einem Drucksensor beschreibt die EP 1 126 259 A1.

Die Offenlegungsschrift DE 101 35 568 A1 offenbart ein Druckmessgerät mit einem Sensorelement auf dessen Rückseite eine Mess- und Betriebsschaltung angeordnet und von einer metallischen Kappe überdeckt ist. Die Kappe ist mittels eines Aktivhartlots mit dem Sensorkörper des Sensorelements entlang einer umlaufenden Fügestelle im Randbereich des Sensorkörpers hermetisch dicht gefügt. Dies ist einerseits sehr aufwändig zu fertigen, setzt die Schaltung bei der Fertigung einer großen thermischen Belastung aus, und kann konstruktionsbedingt zu beachtlichen thermomechanischen Spannungen und Hysterese führen.

Die Offenlegungsschrift DE 102 00 780 A1 offenbart ein Druckmessgerät mit einem keramischen Sensorkörper und einem keramischen Topf, der auf der Rückseite des Sensorkörpers angeordnet und von dem Sensorkörper verschlossen ist. In dem Topf ist eine Mess- und Betriebsschaltung eingeschlossen. Der Topf dient zugleich zur rückseitigen Abstützung des Sensorkörpers, ist also eine mechanisch bestimmende Komponente des Druckmessgeräts. Hierbei ist es besonders aufwändig, eine einerseits hermetisch dichte und andererseits hysteresefreie Verbindung zwischen Topf und Sensorkörper zu erzielen.

Die Offenlegungsschrift DE 103 26 975 A1 offenbart ein Druckmessgerät mit Drucksensorelement, das einen kapazitiven Wandler aufweist, und mit einer Mess- und Betriebsschaltung die in einer hermetisch dichten Kapsel auf einer rückseitigen Oberfläche eines Sensorkörpers der Druckmesszelle angeordnet ist. Die hermetisch dichte Kapsel umfasst einen keramischen oder metallischen Werkstoff, und ist über eine zentrale Stütze oder Anschlussdrähte beabstandet zu der rückseitigen Oberfläche des Sensorkörpers gehalten. Die Anschlussdrähte bilden eine feuchteabhängige parasitäre Kapazität, wobei eine Hydrophobierung der Anschlussdrähte die Feuchteabhängigkeit verringern soll.

Die Offenlegungsschrift DE 10 2008 054 97 A1 offenbart ein Druckmessgerät mit Drucksensorelement auf dessen Rückseite ein Gehäuse zur Kapselung einer Mess- und Betriebsschaltung aufgelötet ist. In dem Gehäuse ist die Mess- und Betriebsschaltung über Bonddrähte an den kapazitiven Wandler des Drucksensorelements angeschlossen, bevor das Gehäuse mit einem mit dem Gehäuse zu verlötenden Deckel geschlossen wird. Die Konstruktion ist sehr aufwändig und bedingt eine vergleichsweise große Gehäusegrundfläche, da innerhalb des Gehäuses noch Bonddrähte von einem freien Bereich einer rückseitigen Sensoroberfläche zur Mess- und Betriebsschaltung zu führen ist. Dies ist einerseits teuer, verringert die freibleibende Fläche auf der Rückseite des Sensorkörpers, an der Sensorelement abgestützt werden kann. Zudem kann eine große Gehäusegrundfläche bei unterschiedlichen Wärmeausdehnungskoeffizienten von Gehäuse, Sensorkörper sowie Lotmaterial zwischen Gehäuse und Sensorkörper größere thermomechanische Spannungen im Sensorkörper bewirken, die in einer Temperaturhysterese resultieren.

Die in der Offenlegungsschrift DE 198 28 598 A1 beschriebene Rotationserfassungsvorrichtung setzt sich zusammen aus einem Magneten und einem Hall-Effekt-Bauelement als Sensorelement und einer Schaltungsbasisplatte, die in einem Ausnehmungsabschnitt des Gehäusekörpers angeordnet und mit einem Dichtungsbauglied bedeckt sind.

Die Offenlegungsschrift DE 102 23 946 A1 bezieht sich auf eine Drehdetektoreinrichtung mit einer Zwischenanordnung, einer Kunststoffbasis und Elektronikbauelementen, wovon eines ein Sensorelement ist. Ein Kunststoffgehäuse deckt vollständig und hermetisch die Zwischenanordnung ab.

Die Offenlegungsschrift DE 10 2012 222 239 A1 beschreibt eine Messeinrichtung zum Messen von in einem Bauteil auftretenden mechanischen Spannungen oder Schwingungen. Dafür befinden sich in dem Bauteil ein elektromechanischer Wandler und eine elektronische Baueinheit zur Aufnahme und Verarbeitung der vom Wandler gelieferten Signale. Die elektronische Baueinheit ist von einem Gehäuse umgeben, wobei eine Kompensationszone der Aufnahme von Relativbewegungen zwischen dem Gehäuse und der elektronischen Baueinheit dient.

In der EP 1 063 504 A1 wird ein Verfahren zur Herstellung eines Sensors beschrieben. Die aktiven Bauteile werden in einem Tragkörper vormontiert, mit Harz überzogen und mit einem thermoplastischen Werkstoff umgossen.

Die EP 1 126 259 A1 beschreibt einen Drucksensor mit einer Messzelle, einer Messzelleneinfassung und einer Sensorelektronik, welche in einem Schutzpolster eingekapselt ist. Das Schutzpolster ist vorzugsweise aus einem sehr weichen Material gefertigt und dient dazu, mechanische Krafteinwirkungen von der Sensorelektronik und von deren Verbindung zu Anschlussleitungen fernzuhalten. Ein Innenraum der Messzelleneinfassung, der durch die Messzelle, den Hohlzylinder und das Schutzpolster begrenzt ist, ist mit einem Verguss ausgefüllt

Die JP S 57 206 842 A offenbart einen Drucksensor aus, bei dem Streukapazitäten reduziert werden sollen. Ein Diaphragma mit einer ersten Elektrode, das sich bei Beaufschlagung mit Druck verbiegt, und ein starres erstes Substrat mit einer zweiten Elektrode sind so abgedichtet, dass sich zwischen den Elektroden eine erste luftdichte Kammer befindet. Eine zweite luftdichte Kammer befindet sich zwischen dem ersten Substrat und einem zweiten Substrat. Auf dem zweiten Substrat ist eine Abschirmplatte aufgebracht, darüber befindet sich ein Harz, auf dem ein Träger mit einer kapazitiven Messschaltung angeordnet ist. Die Messschaltung mit dem Träger ist komplett mit einem Harz verkapselt.

Die US 2015/362392 A1 beschreibt ein Verfahren zur Herstellung eines Drucksensors. Dabei wird durch eine Vergussmasse bewirkt, dass sich unterschiedliche Komponenten des Sensors jeweils auf gleicher Temperatur befinden.

Es ist daher die Aufgabe der vorliegenden Erfindung, ein Messgerät bereitzustellen, das einerseits unempfindlich ist gegenüber Feuchteeinflüssen und andererseits den Einfluss von thermomechanischen Spannungen auf das Messgerät reduziert.

Die Aufgabe wird gelöst durch das Messgerät mit den Merkmalen des ersten Patentanspruchs.

Durch Einkapseln der Komponenten der Mess- und Betriebsschaltung auf einem Trägerkörper sind die Komponenten hinreichend gegen Feuchte geschützt.

Die Mess- und Betriebsschaltung weist vorzugsweise einen A/D-Wandler auf, welcher die Primärsignale frühzeitig in der Verarbeitungskette digitalisiert, sodass die weitere Signalverarbeitung weitgehend unempfindlich gegen Feuchteeinflüsse ist.

In einer Weiterbildung der Erfindung ist der Trägerkörper mittels eines Ball-Grid-Arrays mit Anschlusskontakten des Wandlers in dem Oberflächenabschnitt verbunden. Die Verbindung des Trägerkörpers mit Anschlusskontakten des Wandlers über ein Ball-Grid-Array führt zu extrem kurzen exponierten elektrischen Verbindungen zwischen dem Sensorkörper und dem Trägerkörper. Damit sind die elektrischen Verbindungen, die unmittelbar einen Feuchteeinfluss ausgesetzt sind erheblich reduziert.

In einer Weiterbildung der Erfindung bildet das Gehäuse mit dem Träger ein sogenanntes Chip Scale Package. Dieser aus dem Englischen stammende Fachbegriff, der aber auch im Deutschen üblich ist, steht für eine weitergehende Miniaturisierung als sie mit gewöhnlichen Leiterplatten erhältlich ist. Der Abstand zwischen Kontaktpunkten, beispielsweise in Form eines Ball-Grid-Arrays, mit denen der Träger auf einem Substrat befestigt und/oder an Kontakte angeschlossen wird, beträgt dabei beispielsweise nicht mehr als 2 mm, insbesondere nicht mehr als 1 mm.

In einer Weiterbildung der Erfindung bedeckt eine orthogonale Projektion der Mess- und Betriebsschaltung nicht mehr als 60%, insbesondere nicht mehr als 50% der zweiten Stirnfläche.

Der Sensorkörper kann insbesondere einen keramischen Werkstoff wie Korund oder einen metallischen Werksstoff wie Edelstahl aufweisen. Dann bestehen zwar erhebliche Unterschiede in den Wärmeausdehnungskoeffizienten, aber durch die erhöhte Integration der Mess- und Betriebsschaltung in dem Chip Scale Package ist die Grundfläche des Trägerkörpers vergleichsweise klein, sodass die Auswirkung der unterschiedlichen Wärmeausdehnungskoeffizienten auf die Messgenauigkeit vergleichsweise gering sind.

In einer Weiterbildung der Erfindung umfasst der Trägerkörper ein Kompositmaterial mit einer Matrix aus Kunststoff, beispielsweise einen faserverstärkten Kunststoff, wobei der Kunststoff insbesondere Bismaleimid-Triazin (BT) oder ein Polyimid aufweist, und wobei die Fasern beispielsweise Glas, Keramik wie Al2O3 und Kombinationen aus Glas oder Keramik mit einem Kunststoff wie Polyimid umfassen. In einer Weiterbildung der Erfindung weist der Trägerkörper eine Laminatstruktur auf.

In einer Weiterbildung der Erfindung weist der Sensorkörper im Bereich des Oberflächenabschnitts einen ersten Werkstoff mit einem ersten Wärmeausdehnungskoeffizienten auf, wobei der Trägerkörper einen zweiten Werkstoff mit einem zweiten Wärmeausdehnungskoeffizienten aufweist, wobei die Wärmeausdehnungskoeffizienten um mehr als 20 ppm/K voneinander abweichen, sodass eine Temperaturänderung zu unterschiedlichen Längenausdehnungen führt, die eine Verformung des Sensorkörpers im Bereich Oberflächenabschnitts und eine Verformung des Trägerkörpers bewirken, wobei die Verformungsenergie des Trägerkörpers mindestens das Zehnfache, insbesondere mindestens das Zwanzigfache und bevorzugt mindestens das Vierzigfache der Verformungsenergie des Sensorkörpers beträgt.

Durch geeignete Materialauswahl für den Trägerkörper, beispielsweise eine Matrix von Bismaleimid-Triazin (BT) mit eingebetteten Fasern, lässt sich ein effektives Elastizitätsmodul von etwa 4 GPa für den Trägerkörper erzielen. Das sind etwa 1% des Elastizitätsmoduls eines hochreinen Korundwerkstoffs, der für den Grundkörper eines Sensorkörpers verwendet wird. In dieser Materialpaarung wird ein Großteil der Verformungsenergie zum Ausgleich von Wärmeausdehnungsunterschieden, vom Trägerkörper aufgenommen, sodass die Messgenauigkeit nicht durch übermäßige Verformung des Sensorkörpers beeinträchtigt wird.

In einer Weiterbildung der Erfindung umfasst die Mess- und Betriebsschaltung mehrere Träger, die übereinandergestapelt sind und mit jeweils einem benachbarten Träger über ein Ball-Grid-Array verbunden sind. Durch Stapelung mehrerer Träger kann bei gleicher Grundfläche der Mess- und Betriebsschaltung deren Funktionalität erheblich erweitert werden, sodass ggf. auf eine bei Messgeräten übliche Hauptelektronik verzichtet werden kann, welche sonst für eine weitere Signalverarbeitung und Signalkommunikation vorgesehen ist.

In einer Weiterbildung der Erfindung ist der integrierte Schaltkreis dazu eingerichtet, anhand einer Übertragungsfunktion und des digitalisierten Primärsignals einen die Messgröße repräsentierenden Wert zu berechnen.

In einer Weiterbildung der Erfindung umfasst die Mess- und Betriebsschaltung einen Mikroprozessor, der dazu eingerichtet ist, einen die Messgröße repräsentierenden Wert in ein Signal gemäß einem Kommunikationsprotokoll der Automatisierungstechnik aufzubereiten, insbesondere ein Feldbusprotokoll, beispielsweise ein Protokoll gemäß Foundation Fieldbus, Profibus, HART oder ein Funkprotokoll.

In einer Weiterbildung der Erfindung ist der integrierte Schaltkreis auf einem ersten Träger und der Mikroprozessor auf einem zweiten Träger angeordnet.

In einer Weiterbildung der Erfindung umfasst die Mess- und Betriebsschaltung weiterhin einen Energiespeicher, insbesondere einen Gold-Cap, einen Akkumulator oder eine Batterie.

In einer Weiterbildung der Erfindung ist der Energiespeicher auf einem anderen Träger angeordnet als der integrierte Schaltkreis.

In einer Weiterbildung der Erfindung umfasst der Sensorkörper einen zumindest abschnittsweise zylindrischen Gegenkörper.

In einer Weiterbildung der Erfindung umfasst das Drucksensorelement einen kapazitiven Messwandler, der mindestens eine an der Messmembran angeordnete erste Elektrode und mindestens eine an dem Gegenkörper angeordnete zweite Elektrode aufweist die einander zugewandt sind, wobei die Kapazität zwischen der ersten und der zweiten Elektrode von einer druckabhängigen Auslenkung der Messmembran abhängt, wobei zumindest die zweite Elektrode über mindestens eine Durchführung durch den Gegenkörper mit der Mess- und Betriebsschaltung verbunden ist. Anstelle des kapazitiven Wandlers kann gleichermaßen ein (piezo-)resistiver Wandler verwendet werden.

Die Erfindung wird anhand des in der Zeichnung dargestellten Ausführungsbeispiels näher erläutert. Es zeigt:

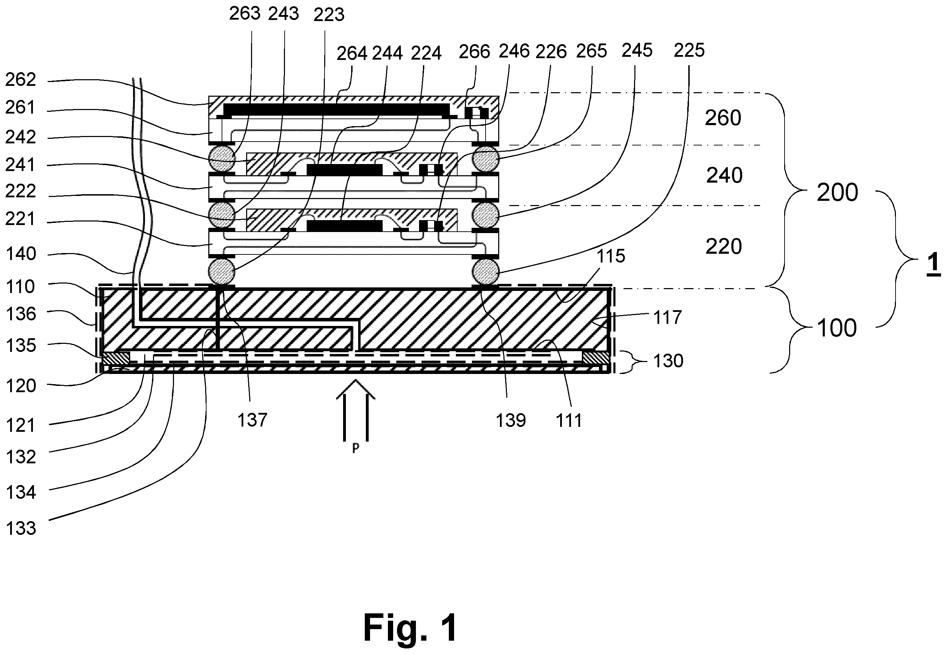

Fig. 1: einen schematischen Längsschnitt durch ein Ausführungsbeispiel eines erfindungsgemäßen Messgeräts.

Das in Fig. 1 dargestellte Ausführungsbeispiel eines erfindungsgemäßen Messgeräts ist ein Druckmessgerät 1, welches ein Drucksensorelement 100 sowie eine Mess- und Betriebsschaltung 200 aufweist.

Das Drucksensorelement 100 umfasst einen zylindrischen, keramischen Gegenkörper 110 und eine keramische Messmembran 120, die unter Bildung einer Messkammer 121 mittels einer umlaufenden, leitfähigen Fügestelle 135, die ein Aktivhartlot aufweist, mit einer ersten Stirnfläche 111 des Gegenkörpers 110 verbunden ist. Das Drucksensorelement 100 umfasst weiterhin einen kapazitiven Wandler 130, der mindestens eine Messelektrode 132 an der ersten Stirnfläche 111 des Gegenkörpers 110 und eine Membranelektrode 134 an einer dem Gegenkörper 110 zugewandten Oberfläche der Messmembran 120 aufweist.

Die Messelektrode 132 ist über eine elektrische Durchführung 133 mit einem ersten durch eine Metallschicht gebildeten Kontaktpunkt 137 an einer zweiten Stirnfläche 115 des Gegenkörpers 110 galvanisch verbunden. Die Membranelektrode 134 ist über die Fügestelle 135 und eine metallische Beschichtung 136 einer Mantelfläche 117 und Teilen der zweiten Stirnfläche 115 des Gegenkörpers 110 mit einem zweiten durch eine Metallschicht gebildeten Kontaktpunkt 139 galvanisch verbunden.

Durch den Gegenkörper 110 erstreckt sich ein Referenzdruckkanal 140, der in der Messkammer 121 mündet, sodass die Messkammer 121 mit einem Referenzdruck beaufschlagbar ist. Die Messmembran 120 erfährt demnach eine Auslenkung, die von einer Differenz zwischen einem Druck p auf der Außenseite der Messmembran 120 und dem Referenzdruck in der Messkammer 121 abhängt. Die Auslenkung wird Mittels des kapazitiven Wandlers 130 erfasst, der an die Mess- und Betriebsschaltung 200 angeschlossen ist. Der kapazitive Wandler 130 umfasst in der Darstellung des Ausführungsbeispiels nur eine gegenkörperseitige Elektrode, nämlich die Messelektrode 132, tatsächlich können auch Elektroden am Gegenkörper angeordnet sein, nämlich eine zentrale Messelektrode mit einer Kapazität CP zur Membranelektrode 134 und eine, die Messelektrode ringförmig umgebende, in der Ruhelage der Messmembran kapazitätsgleiche Referenzelektrode mit einer Kapazität CR zur Membranelektrode. Die Übertragungsfunktion eines solchen kapazitiven Wandlers, der einen Differentialkondensator umfasst, ist in erster Näherung proportional zu (CP-CR)/CP.

Im hier dargestellten Ausführungsbeispiel umfasst die Mess- und Betriebsschaltung 200 einen Stapel von integriert gekapselten Systemen 220, 240, 260, sogenannten System-In-Package-Anordnungen 220, 240, 260, die im folgenden SIP genannt werden. Wenngleich hier drei SIP 220, 240, 260 vorgesehen sind, wird die Erfindung auch durch ein Messgerät mit nur einem ersten SIP 220 realisiert.

Das erste SIP 220 umfasst einen Trägerkörper 221, welcher ein Laminat aus mehreren Lagen eines faserverstärkten Kunststoffs (beispielsweise eine Kunststoffmatrix aus Bismaleimid-Triazin, in welche Fasern eingebettet sind, beispielsweise Polyimidfasern, die ihrerseits eine Glas- oder Keramikbeschichtung aufweisen können) ist. Zwischen den Lagen und durch die Lagen der Laminatstruktur sind Leiterbahnen präpariert, um die Komponenten des ersten SIP 220 zu kontaktieren, um sie miteinander und mit dem kapazitiven Wandler 130 des Sensorelements 100 zu verbinden. Der Trägerkörper ist mit einem Ball Grid Array mit der zweiten Stirnfläche 115 des Gegenkörpers 110 fest verbunden, wobei eine erste Lotkugel 223 des Ball Grid Arrays mit dem ersten Kontaktpunkt 137 galvanisch verbunden ist, und wobei eine zweite Lotkugel 225 mit dem zweiten Kontaktpunkt 139 galvanisch verbunden ist, um die Elektroden des kapazitiven Wandlers 130 an das erste SIP 220 die Mess- und Betriebsschaltung 200 anzuschließen. Wenngleich in der Zeichnung nur zwei Kontakte dargestellt sind, können tatsächlich mehrere Kontakte vorhanden sein, insbesondere mindestens drei, nämlich für CP, CR und die Messmembran. Das erste SIP 220 umfasst einen ASIC 224, welcher auf dem Trägerkörper 221 angeordnet und dazu eingerichtet ist, Primärsignale des kapazitiven Wandlers zu digitalisieren und in Abhängigkeit von den digitalisierten Werten anhand einer Übertragungsfunktion einen Druckmesswert bereitzustellen. Das erste SIP 220 umfasst weiterhin passive Komponenten 226, insbesondere Widerstandselemente und Kapazitäten, die benachbart zu dem ASIC 224 auf dem Trägerkörper 224 angeordnet und dazu eingerichtet sind, eine stabile Versorgungsspannung für den ASIC bereitzustellen. Der ASIC 224 und die passiven Komponenten 226 sind mit einer Formmasse 222 mittels Spritzgießen auf dem Trägerkörper 221 eingekapselt. Die Formmasse kann insbesondere ein Epoxidharz umfassen. An der von dem Sensorelement 110 abgewandten Oberseite des Trägerkörpers 221 sind außerhalb der durch die Formmasse 222 gebildete Kapsel mit den eingekapselten Komponenten 224, 226 weitere Kontaktpunkte angeordnet, an welche Signalpfade und die elektrische Versorgung des ersten SIP 220 anzuschließen sind.

Im Ausführungsbeispiel ist an den Kontaktpunkten ein zweites SIP 240 mit einem zweiten Ball Grid Array befestigt, dessen Lotkugeln 243 und 245 in der Zeichnung dargestellt sind, tatsächlich sind hier deutlich mehr Kontakte vorhanden, um den Datenaustausch zwischen den SIP 220, 240 und die Energieversorgung des ersten SIP 220 zu ermöglichen. Das zweite SIP 240 umfasst ebenfalls einen Trägerkörper 241 und mit Formmasse 242 eingekapselte Komponenten 244, 246 der Mess- und Betriebsschaltung 200. Die Komponenten 244, 246 können ein Spannungsregler-Modul 246 und ein Microcontroller für das Wireless-HART-Protokoll 244 zur Kommunikation mit einem Leitsystem der Prozessautomatisierungstechnik, insbesondere zur Messwertübertragung und/oder ein Microcontroller für das Bluetooth-Protokoll zur Messwertübertragung und/oder Parametrierung der Mess- und Betriebsschaltung 200 sein. Das zweite SIP 240 weist an der von dem Sensorelement 110 abgewandten Oberseite des zweiten Trägerkörpers 241 außerhalb der durch die Formmasse 242 gebildete Kapsel weitere Kontaktpunkte auf, an welche Signalpfade und die elektrische Versorgung des ersten und zweiten SIP 220, 240 anzuschließen sind.

Im Ausführungsbeispiel ist an den Kontaktpunkten ein drittes SIP 260 mit einem dritten Ball Grid Array befestigt, dessen Lotkugeln 263 und 265 in der Zeichnung dargestellt sind, tatsächlich sind hier deutlich mehr Kontakte vorhanden, um den Datenaustausch zwischen den SIP und die Energieversorgung des ersten und zweiten SIP 220, 240 zu ermöglichen. Das dritte SIP 260 umfasst ebenfalls einen Trägerkörper 261 und mit Formmasse 262 eingekapselte Komponenten 264, 266 der Mess- und Betriebsschaltung umfassend hier eine Batterie 264 zur Energieversorgung der Mess- und Betriebsschaltung 200 und ein Antennenmodul 266 zur Kommunikation mit einem Leitsystem oder einem Bedientool über Wireless HART bzw. Bluetooth.

Die Materialien der Trägerkörper 241, 261 und der Formmassen 242, 262 des zweiten SIP 240 und des dritten SIP 260 können insbesondere die gleichen Materialien wie jene des Trägerkörpers 221 bzw. der Formmassen des ersten SIP 220 sein.

## Patentansprüche

1. Messgerät (1), umfassend:
ein Sensorelement (100) zum Erfassen einer Messgröße,
wobei das Sensorelement (100) einen elektrischen Wandler (130) zum Bereitstellen von messgrößenabhängigen elektrischen Primärsignalen und einen Sensorkörper (110) mit zumindest einem ebenen Oberflächenabschnitt (115) aufweist,
wobei das Sensorelement (100) ein Drucksensorelement aufweist,
wobei das Drucksensorelement (100) eine Messmembran (120) umfasst,
wobei der Sensorkörper (110) einen Gegenkörper (110) umfasst, und
wobei die Messmembran (120) an einer ersten Stirnfläche (111) des Gegenkörpers (110) druckdicht mit dem Gegenkörper (110) verbunden ist;
eine Mess- und Betriebsschaltung (200) zum Treiben des elektrischen Wandlers (130) und zum Verarbeiten der von dem elektrischen Wandler (130) bereitgestellten Primärsignale,
wobei die Mess- und Betriebsschaltung (200) mindestens einen Träger und mehrere Schaltungskomponenten aufweist, welche mindestens einen integrierten Schaltkreis (224, 244, 246) und mindestens ein diskretes, passives elektrisches Bauelement (226, 266) umfassen,
wobei die Mess- und Betriebsschaltung (200) an dem Oberflächenabschnitt (115) einer von der Messmembran (120) abgewandten zweiten Stirnfläche des Gegenkörpers (110) angeordnet ist, und
wobei der Träger einen elektrisch isolierenden Trägerkörper (221, 241, 261) und Leiterbahnen aufweist, die in dem Trägerkörper (221, 241, 261) und/oder an mindestens einer Trägerkörperoberfläche des Trägerkörpers (221, 241, 261) verlaufen,
**dadurch gekennzeichnet,**
**dass** der integrierte Schaltkreis (224, 244, 246) und das passive elektrische Bauelement (226, 266) der Mess- und Betriebsschaltung (200) an der von dem Sensorelement (100) abgewandten Trägerkörperoberfläche des Trägerkörpers (221, 241, 261) angeordnet und durch die Leiterbahnen kontaktiert sind;
**dass** der mindestens eine Trägerkörper (221) mit der dem Sensorelement (100) zugewandten Trägerkörperoberfläche an dem Oberflächenabschnitt (115) des Sensorkörpers (110) des Sensorelements (100) fixiert ist,
**dass** der Wandler (130) mit Schaltungskomponenten (224, 226) der Mess- und Betriebsschaltung (200) über Leiterbahnen elektrisch verbunden ist, und
**dass** die auf dem Trägerkörper (221, 241, 261) angeordneten Schaltungskomponenten (224, 246, 244, 246, 264, 266) der Mess- und Betriebsschaltung (200) mit einer Formmasse (222, 242, 262) eingekapselt sind,
und wobei der Gegenkörper (110) und die Messmembran (120) eine Messkammer (121) mittels einer umlaufenden Fügestelle (135) bilden.

2. Messgerät (1) nach Anspruch 1, wobei der Trägerkörper (221) mittels eines Ball-Grid-Arrays (223, 225) mit Anschlusskontakten des Wandlers (130) in dem Oberflächenabschnitt (115) verbunden ist.

3. Messgerät (1) nach Anspruch 1 oder 2, wobei die eingekapselten Schaltungskomponenten (224, 246, 244, 246, 264, 266) mit dem Träger ein Chip Scale Package bildet.

4. Messgerät (1) nach einem der Ansprüche 1 bis 3, wobei der Trägerkörper (221) ein Kompositmaterial mit einer Matrix aus Kunststoff umfasst und eine Laminatstruktur aufweist.

5. Messgerät (1) nach einem der Ansprüche 1 bis 4, wobei die Mess- und Betriebsschaltung (200) mehrere Träger (221, 241, 261) umfasst, die übereinandergestapelt sind und mit jeweils einem benachbarten Träger (221, 241, 261) über ein Ball-Grid-Array (243, 245, 263, 265) verbunden sind.

6. Messgerät (1) nach einem der Ansprüche 1 bis 5, wobei der integrierte Schaltkreis (224, 244, 246) dazu eingerichtet ist, anhand einer Übertragungsfunktion und anhand des digitalisierten Primärsignals einen die Messgröße repräsentierenden Wert zu berechnen.

7. Messgerät (1) nach einem der Ansprüche 1 bis 6, wobei die Mess- und Betriebsschaltung (200) einen Mikroprozessor (244) umfasst, der dazu eingerichtet ist, einen die Messgröße repräsentierenden Wert in ein Signal gemäß einem Kommunikationsprotokoll der Automatisierungstechnik aufzubereiten, und wobei der integrierte Schaltkreis (224, 244, 246) auf einem ersten Träger und der Mikroprozessor auf einem zweiten Träger angeordnet ist.

8. Messgerät (1) nach einem der Ansprüche 1 bis 7, wobei die Mess- und Betriebsschaltung (200) weiterhin einen Energiespeicher umfasst, der auf einem anderen Träger angeordnet ist als der integrierte Schaltkreis (224, 244, 246).

9. Messgerät (1) nach einem der Ansprüche 1 bis 8, wobei der Gegenkörper (110) zumindest abschnittsweise zylindrisch ist.

10. Messgerät (1) nach Anspruch 9, wobei das Drucksensorelement (100) einen kapazitiven Messwandler (130) umfasst, der eine an der Messmembran (120) angeordnete Membranelektrode (134) und eine an dem Gegenkörper (110) angeordnete Messelektrode (132) aufweist, die einander zugewandt sind, wobei die Kapazität zwischen den Elektroden (132, 134) von einer druckabhängigen Auslenkung der Messmembran (120) abhängt, und wobei die Messelektrode (132) über eine elektrische Durchführung (133) durch den Gegenkörper (110) mit der Mess- und Betriebsschaltung (200) verbunden ist.

11. Messgerät (1) nach Anspruch 9 oder 10, wobei eine orthogonale Projektion der Mess- und Betriebsschaltung (200) nicht mehr als 60% der zweiten Stirnfläche (115) bedeckt.

12. Messgerät (1) nach einem der Ansprüche 1 bis 11, wobei der Sensorkörper (110) im Bereich des Oberflächenabschnitts einen ersten Werkstoff mit einem ersten Wärmeausdehnungskoeffizienten aufweist und wobei der Trägerkörper (221, 241, 261) einen zweiten Werkstoff mit einem zweiten Wärmeausdehnungskoeffizienten aufweist, wobei die Wärmeausdehnungskoeffizienten um mehr als 20 ppm/K voneinander abweichen, sodass eine Temperaturänderung zu unterschiedlichen Längenausdehnungen führt, die eine Verformung des Sensorkörpers (110) im Bereich des Oberflächenabschnitts und eine Verformung des Trägerkörpers (221, 241, 261) bewirken, wobei die Verformungsenergie des Trägerkörpers (221, 241, 261) mindestens das Zehnfache der Verformungsenergie des Sensorkörpers (110) beträgt.

## Claims

1. A measuring device (1), comprising:
A sensor element (100) for detecting a measured variable,
wherein the sensor element (100) has an electrical converter (130) for supplying electrical primary signals dependent on the measured variable and a sensor body (110) with at least one level surface section (115),
wherein the sensor element (100) has a pressure sensor element, wherein the pressure sensor element (100) comprises a measuring membrane (120), wherein the sensor body (110) comprises a counterpart body (110), and
wherein the measuring membrane (120) has a pressure-tight connection to the counterpart body (110) at a first end face (111) of the counterpart body (110);
a measuring and operating circuit (200) for driving the electrical converter (130) and for processing the primary signals supplied by the electrical converter (130),
wherein the measuring and operating circuit (200) has at least one support and multiple circuit components which comprise at least one integrated switching circuit (224, 244, 246) and at least one discrete, passive electrical component (226, 266),
wherein the measuring and operating circuit (200) is arranged on the surface section (115) of a second end face of the counterpart body (110) facing away from the measuring membrane (120), and
wherein the support has an electrically insulating support body (221, 241, 261) and traces which run in the support body (221, 241, 261) and/or on at least one support body surface of the support body (221, 241, 261),
**characterized in that**
the integrated switching circuit (224, 244, 246) and the passive electrical component (226, 266) of the measuring and operating circuit (200) are arranged on the support body surface of the support body (221, 241, 261) facing away from the sensor element (100) and are connected by the traces;
the at least one support body (221) with the support body surface facing toward the sensor element (100) is secured to the surface section (115) of the sensor body (110) of the sensor element (100),
the converter (130) is electrically connected to circuit components (224, 226) of the measuring and operating circuit (200) via traces, and
the circuit components (224, 246, 244, 246, 264, 266) of the measuring and operating circuit (200) arranged on the support body (221, 241, 261) are encapsulated with a molding compound (222, 242, 262), and wherein the counterpart body (110) and the measuring membrane (120) form a measuring chamber (121) by means of a surrounding joint (135).

2. The measuring device (1) as claimed in claim 1, wherein the support body (221) is connected to terminal contacts of the converter (130) in the surface section (115) by means of a ball grid array (223, 225).

3. The measuring device (1) as claimed in claim 1 or 2, wherein the encapsulated circuit components (224, 246, 244, 246, 264, 266) form a chip scale package together with the support.

4. The measuring device (1) as claimed in one of claims 1 to 3, wherein the support body (221) comprises a composite material with a matrix of plastic and a laminated structure.

5. The measuring device (1) as claimed in one of claims 1 to 4, wherein the measuring and operating circuit (200) comprises several supports (221, 241, 261) which are stacked on top of each other and are each connected to an adjacent support (221, 241, 261) via a ball grid array (243, 245, 263, 265).

6. The measuring device (1) as claimed in one of claims 1 to 5, wherein the integrated switching circuit (224, 244, 246) is configured to calculate a value representing the measured variable based on a transfer function and based on the digitized primary signal.

7. The measuring device (1) as claimed in one of claims 1 to 6, wherein the measuring and operating circuit (200) comprises a microprocessor (244) which is configured to prepare a value representing the measured variable into a signal in accordance with an automation communication protocol, and wherein the integrated switching circuit (224, 244, 246) is arranged on a first support and the microprocessor is arranged on a second support.

8. The measuring device (1) as claimed in one of claims 1 to 7, wherein the measuring and operating circuit (200) further comprises an energy storage unit which is arranged on a different support than the integrated switching circuit (224, 244, 246).

9. The measuring device (1) as claimed in one of claims 1 to 8, wherein the counterpart body (110) is cylindrical at least in sections.

10. The measuring device (1) as claimed in claim 9, wherein the pressure sensor element (100) comprises a capacitive measuring transducer (130) which has a membrane electrode (134) arranged on the measuring membrane (120) and a measuring electrode (132) arranged on the counterpart body (110), which face each other, wherein the capacitance between the electrodes (132, 134) depends on a pressure-dependent deflection of the measuring membrane (120), and wherein the measuring electrode (132) is connected to the measuring and operating circuit (200) via an electrical feedthrough (133) through the counterpart body (110).

11. The measuring device (1) as claimed in claim 9 or 10, wherein an orthogonal projection of the measuring and operating circuit (200) covers no more than 60% of the second end face (115).

12. The measuring device (1) as claimed in one of claims 1 to 11, wherein the sensor body (110) has, in the area of the surface section, a first material with a first coefficient of thermal expansion and wherein the support body (221, 241, 261) has a second material with a second coefficient of thermal expansion, wherein the coefficients of thermal expansion differ from each other by more than 20 ppm/K so that a temperature change leads to different elongations which cause deformation of the sensor body (110) in the area of the surface section and deformation of the support body (221, 241, 261), wherein the deformation energy of the support body (221, 241, 261) is at least ten times the deformation energy of the sensor body (110).

## Revendications

1. Appareil de mesure (1), comprenant :
un élément capteur (100) destiné à acquérir une grandeur de mesure,
l'élément capteur (100) comprenant un convertisseur électrique (130) destiné à fournir des signaux électriques primaires dépendant de la grandeur de mesure et un corps de capteur (110) avec au moins une section de surface plane (115),
l'élément capteur (100) étant un élément capteur de pression,
l'élément capteur de pression (100) comprenant une membrane de mesure (120),
le corps de capteur (110) comprenant un contre-corps (110), et
la membrane de mesure (120) étant reliée de manière étanche à la pression au contre-corps (110) sur une première surface frontale (111) du contre-corps (110) ;
un circuit de mesure et de fonctionnement (200) destiné à commander le transducteur électrique (130) et à traiter les signaux primaires fournis par le transducteur électrique (130),
le circuit de mesure et de fonctionnement (200) présentant au moins un support et plusieurs composants de circuit qui comprennent au moins un circuit intégré (224, 244, 246) et au moins un composant électrique passif discret (226, 266),
le support présentant un corps de support électriquement isolant (221, 241, 261) et des pistes conductrices qui s'étendent dans le corps de support (221, 241, 261) et/ou sur au moins une surface du corps de support (221, 241, 261),
**caractérisé**
**en ce que** le circuit intégré (224, 244, 246) et le composant électrique passif (226, 266) du circuit de mesure et de fonctionnement (200) sont disposés sur la surface du corps de support (221, 241, 261) opposée à l'élément capteur (100) et sont mis en contact par les pistes conductrices ;
**en ce que** l'au moins un corps de support (221) est fixé par la surface du corps de support tournée vers l'élément capteur (100) sur la section de surface (115) du corps de capteur (110) de l'élément capteur (100),
**en ce que** le transducteur (130) est relié électriquement à des composants de circuit (224, 226) du circuit de mesure et de fonctionnement (200) par des pistes conductrices, et
**en ce que** les composants de circuit (224, 246, 244, 246, 264, 266) du circuit de mesure et de fonctionnement (200) disposés sur le corps de support (221, 241, 261) sont encapsulés avec une matière moulable (222, 242, 262),
et le contre-corps (110) et la membrane de mesure (120) formant une chambre de mesure (121) au moyen d'un point d'assemblage périphérique (135).

2. Appareil de mesure (1) selon la revendication 1, pour lequel le corps de support (221) est raccordé au moyen d'une matrice de billes (223, 225) à des contacts de raccordement du transducteur (130) dans la section de surface (115).

3. Appareil de mesure (1) selon la revendication 1 ou 2, pour lequel les composants de circuit encapsulés (224, 246, 244, 246, 264, 266) forment avec le support un boîtier à l'échelle de la puce.

4. Appareil de mesure (1) selon l'une des revendications 1 à 3, pour lequel le corps de support (221) comprend un matériau composite avec une matrice en matière plastique et présente une structure stratifiée.

5. Appareil de mesure (1) selon l'une des revendications 1 à 4, pour lequel le circuit de mesure et de fonctionnement (200) comprend une pluralité de supports (221, 241, 261) empilés les uns sur les autres et reliés chacun à un support adjacent (221, 241, 261) par l'intermédiaire d'une matrice de billes (243, 245, 263, 265).

6. Appareil de mesure (1) selon l'une des revendications 1 à 5, pour lequel le circuit intégré (224, 244, 246) est conçu pour calculer une valeur représentative de la grandeur mesurée à partir d'une fonction de transfert et à partir du signal primaire numérisé.

7. Appareil de mesure (1) selon l'une des revendications 1 à 6, pour lequel le circuit de mesure et de fonctionnement (200) comprend un microprocesseur (244), lequel est conçu pour convertir une valeur représentative de la grandeur mesurée en un signal selon un protocole de communication de la technique d'automatisation, et le circuit intégré (224, 244, 246) étant disposé sur un premier support et le microprocesseur sur un deuxième support.

8. Appareil de mesure (1) selon l'une des revendications 1 à 7, pour lequel le circuit de mesure et de fonctionnement (200) comprend en outre un accumulateur d'énergie disposé sur un support différent de celui du circuit intégré (224, 244, 246).

9. Appareil de mesure (1) selon l'une des revendications 1 à 8, pour lequel le contre-corps (110) est cylindrique au moins par tronçons.

10. Appareil de mesure (1) selon la revendication 9, pour lequel l'élément capteur de pression (100) comprend un transducteur capacitif (130), lequel transducteur comprend une électrode à membrane (134) disposée sur la membrane de mesure (120) et une électrode de mesure (132) disposée sur le contre-corps (110), lesquelles électrodes sont tournées l'une vers l'autre, la capacité entre les électrodes (132, 134) dépendant d'une déviation de la membrane de mesure (120) en fonction de la pression, et l'électrode de mesure (132) étant reliée au circuit de mesure et de fonctionnement (200) par l'intermédiaire d'une traversée électrique (133) à travers le contre-corps (110).

11. Appareil de mesure (1) selon la revendication 9 ou 10, pour lequel une projection orthogonale du circuit de mesure et de fonctionnement (200) ne couvre pas plus de 60 % de la deuxième surface frontale (115).

12. Appareil de mesure (1) selon l'une des revendications 1 à 11,
pour lequel le corps de capteur (110) présente, dans la zone de la section de surface, un premier matériau avec un premier coefficient de dilatation thermique et
pour lequel le corps de support (221, 241, 261) présente un deuxième matériau avec un deuxième coefficient de dilatation thermique,
les coefficients de dilatation thermique différant les uns des autres de plus de 20 ppm/K, de sorte qu'une variation de température entraîne des dilatations longitudinales différentes, lesquelles dilatations provoquent une déformation du corps de capteur (110) dans la zone de la section de surface et une déformation du corps de support (221, 241, 261), l'énergie de déformation du corps de support (221, 241, 261) étant au moins dix fois supérieure à l'énergie de déformation du corps de capteur (110).
